# EUROPEAN PATENT APPLICATION

(11) **EP 2 138 607 A1**
(43) Date of publication of application: **30.12.2009**
(21) Application number: 08158896.4
(22) Date of filing: 24.06.2008
(51) Int. Cl.: C25D 1/04, C25D 3/22, H01L 31/18, H01B 13/00

(54) **Process for preparing a flexible substrate carrying a film of a transparent conductive oxide**

(71) Applicant: Nederlandse Organisatie voor Toegepast- Natuurwetenschappelijk Onderzoek TNO, 2628 VK Delft (NL)
(72) Inventor: Hovestad, Arjan, 5231 PK 's-Hertogenbosch (NL); van Neer, Martin, Karolus, Petrus, 6141 SA Limbricht (NL)
(74) Representative: Hatzmann, Martin

(57) **Abstract**

The invention provides a process for preparing a flexible substrate onto which a film of a transparent conductive oxide has been applied, which process comprises the steps of:
(a) providing a metal carrier;
(b) depositing a film of a transparent conductive oxide onto the metal carrier;
(c) adhering a flexible substrate onto the film of the transparent conductive oxide; and
(d) removing the metal carrier from the film of the transparent conductive oxide.

The invention further provides an electronic device comprising a flexible substrate as obtained with said process.

## Description

The present invention relates to a process for preparing a flexible substrate onto which a film of a transparent conductive oxide has been applied, and an electronic device comprising a flexible substrate as obtained with such a process.

Films of transparent conductive oxides (TCOs) are used in many applications such as, for instance, windows, solar cells, displays, light emitting diodes (LEDs). The attractiveness of TCOs resides in their very good optical and electrical properties. TCOs are typically directly deposited on substrates that have a high thermal resistance, like glass. However, there is an increasing demand to use substrates that are cheap, flexible and lightweight. Substrates that meet these requirements are, for instance, polymer foils. A disadvantage of applying TCOs onto such flexible substrates is that one is restricted to relatively low deposition temperatures because of the fact that at conventional high deposition temperatures the flexible substrate melts.

Object of the present invention is therefore to provide an improved process in which onto a flexible substrate a film of a transparent conductive oxide is applied.

It has now been found that this object can be realised when a film of a transparent conductive oxide is first deposited on a metal carrier, a flexible substrate is then adhered to the film obtained, and subsequently the metal carrier is removed from the film.

Accordingly, the present invention relates to a process for preparing a flexible substrate onto which a film of a transparent conductive oxide has been applied, which process comprises the steps of:
(a) providing a metal carrier;
(b) depositing a film of a transparent conductive oxide onto the metal carrier;
(c) adhering a flexible substrate onto the film of the transparent conductive oxide; and
(d) removing the metal carrier from the film of the transparent conductive oxide.

The process in accordance with the present invention has the advantages that it is cheaper and provides less chemical waste when compared to similar processes wherein TCOs are applied onto flexible substrates by chemical dissolution of the metallic carrier. In addition, the present process has the advantage that it allows for a much wider choice of TCOs that can be used, which is due to the fact that no or non-aggressive chemical dissolution is used.

The metal carrier to be used in accordance with the present invention can suitable be a foil of copper, nickel, steel, stainless steel, aluminium, gold, molybdenum, tungsten, tin, titanium, zinc, or any alloy thereof.

Preferably, the metal carrier comprises copper or nickel. The metal carrier can for instance be a copper or nickel foil.
In the process according to the present invention the transparent conductive oxide can suitably be selected from the group consisting of ZnO, In₂O₃, SnO₂, CdO, PbO, NiO, CO₂O₃, Cu₂O, Ag₂O, Al₂O₃, Ga₂O₃ or mixtures thereof. The transparent conductive oxide may optionally be doped, such as with fluorine. The dopant depends on the type of TCO. For instance, in case the TCO is ZnO suitable dopants are F, Cl, Al, B, P, N, In, and Ga. In case the TCO is SnO₂ suitable dopants are F, Mo, and Sb. In case the TCO is In₂O₃ suitable dopants are Sn, Sb and Mo.

Preferably, the transparent conductive oxide comprises ZnO or SnO₂.

In a preferred embodiment of the present invention the transparent conductive oxide is doped with fluorine.

Suitably, in step (b) the film of the transparent conductive oxide is deposited onto the metal carrier by means of a gas-phase deposition process or a wet chemical deposition process. The most commonly used deposition technique for transparent conductive oxides is sputtering. For this technique targets of the material itself can suitable be used for depositing the transparent conductive oxide. For chemical vapour deposition a wide range of precursors is available. Also for wet chemical processes it is possible to use suitable precursors of the transparent conductive oxide. Suitable precursors depend on the transparent conductive oxide to be deposited and can be readily determined by the person skilled in the art.

Suitable examples of such gas-phase deposition processes include sputtering (DC (direct current), RF (radiofrequency) or magnetron), pulsed layer deposition, chemical vapour deposition, and evaporation (reactive, electron-beam or thermal).

Suitable examples of such a wet chemical deposition process include electrodeposition, chemical bath deposition, sol-gel deposition and spray pyrolysis.

Preferably, in step (b) the film of the transparent conductive oxide is deposited onto the metal carrier by means of a wet chemical deposition process.

In the process according to the present invention the flexible substrate can suitably be adhered to the film of the transparent conductive oxide by means of an adhesive.

Adhesives capable of adhering a flexible substrate to a transparent conductive oxide film are widely available in the art. The choice of adhesive is not of particular importance. The person skilled in the art will be able to determine suitable adhesives to be used in accordance with the invention. For instance standard epoxy-based adhesives may be applied.

The flexible substrate to be used in accordance with the present invention can suitably be a polymer and/or a textile.

Suitable examples of polymers to be used as flexible substrate include polyethylene terephthalate, polyethylene naphthalate, polyvinylchloride, polystyrene, polyethylene, polyamide, poly(tetrafluoroethene) and polyimide.

Suitable examples of textiles to be used as flexible substrate are textiles comprising cotton, nylon, polyester, aramid, and/or polyacrylonitrile.

Preferably, the flexible substrate comprises a polymer.

In step (d) of the process of the present invention the metal carrier is preferably mechanically removed from the film of the transparent conductive oxide. This can for instance be performed in a roll-to-roll production unit in which the metal carrier and the flexible substrate are transferred from a joint roll to two distinct rolls.

Suitable steps c) and d) are carried out in a roll-to-roll process, for instance by unwinding a roll of metal carrier with a transparent conductive oxide film and simultaneously unwinding a roll of flexible substrate having a higher adherence to the transparent conductive oxide film than the metal carrier. Thereafter the metal carrier with the transparent conductive oxide film can be pressed against the flexible substrate on a joint roll. Subsequently, the flexible plastic foil and the metal carrier can be wound on different rolls, while the transparent conductive oxide is removed from the metal carrier and adheres to the flexible plastic foil.

In a particularly attractive embodiment of the present invention between steps (a) and (b) the metal carrier is chemically or electrochemically passivated (i.e. the reactivity of the metal foil is reduced) and a metal film is deposited on the passivated metal carrier, the film of the transparent conductive oxide is deposited in step (b) onto the metal film, whereby after step (d) the metal film is removed from the film of the transparent conductive oxide.

In such an embodiment the metal carrier can suitably be chemically or electrochemically passivated by means of chromic acid or nitric acid, whereas the metal film can suitably be deposited onto the metal carrier by means of electrodeposition.

Suitably, the metal film to be used in such an embodiment comprises copper, nickel, cobalt, tin, silver, manganese, indium, and/or zinc. Preferably, the metal film is a film of copper or silver.

In case the metal carrier is provided with a metal film, after step (d) the metal film can suitably be removed from the film of the transparent conductive oxide by selectively dissolving the metal film in a solution.

Suitably, such a solution comprises an oxidiser and a complex forming agent to dissolve the metal. It is preferred that the solution has a pH in the range of 7-11, more preferably in the range of 8-10.

The oxidiser to be used in such a solution can suitably be selected from the group consisting of persulphates, peroxides, dissolved oxygen, ferricyanides, and chlorates.

The method of the invention can suitably be used in a roll-to-roll process.

The present invention also relates to an electronic device comprising a flexible substrate onto which a film of a transparent conductive oxide has been applied in accordance with the present invention.

Suitable examples of such electronic devices include OLEDs (organic light emitting diodes), thin film photovoltaic cells, displays and touch screens.

### Examples

### Example 1

Standard commercial copper foil was pretreated by degreasing with ethanol, hot air-drying, activating in sulphuric acid, rinsing in demineralised water and ethanol and hot air-drying. The cleaned copper foil was dipped in a solution of 0.1 M zinc nitrate, 0.1 M sodium nitrate at 700 °C. The copper foil was made cathodic in the solution and a zinc oxide film was electrodeposited at a voltage of -0.9 V vs Ag/AgCl for 15 minutes. After electrodeposition the ZnO film adhered strongly enough to prevent easy separation. Polyvinyl chloride (PVC) foil with adhesive was applied to the ZnO film. The copper foil was mechanically separated form the ZnO film leaving a ZnO coated PVC foil.

### Example 2

High quality electrodeposited sulphamate nickel foil was degreased with ethanol rinsed with demineralised water and hot air dried. The cleaned nickel foil was dipped in a solution of 0.1 M zinc nitrate, 0.1 M sodium nitrate at 700 °C. The nickel foil was made cathodic in the solution and a zinc oxide film was electrodeposited at a voltage of -0.9 V vs Ag/AgCl for 15 minutes. Polyvinyl chloride (PVC) foil with adhesive was applied to the ZnO film. The nickel foil was mechanically separated form the ZnO film leaving a ZnO coated PVC foil.

### Example 3

High quality electrodeposited sulphamate nickel foil was degreased with ethanol rinsed with demineralised water and hot air dried. The nickel foil was passivated in 10 g/l sodium chromate for 4 minutes. A 2 micron thick copper film was deposited on the passivated nickel foil using a standard acid copper plating bath. A zinc oxide film was electrodeposited on the nickel foil at a voltage of -0.9 V vs Ag/AgCl in a solution of 0.1 M zinc nitrate, 0.1 M sodium nitrate at 700°C for 15 minutes. Polyvinyl chloride (PVC) foil with adhesive was applied to the ZnO film. The nickel foil was mechanically separated from the Cu film leaving a ZnO and copper coated PVC foil. The PVC foil with ZnO and Cu film was dipped in a solution of 100 g/l sodium persulphate and 100 g/l sodium gluconate at pH 9. After 15 minutes the copper film was completely dissolved in the solution leaving ZnO coated PVC foil.

### Example 4

As 3, but after separation from the nickel foil the PVC foil with ZnO and Cu film was dipped in a solution of 100 g/l potassium ferricyanide and 100 g/l sodium gluconate at pH 9. After 15 minutes the copper film was completely dissolved in the solution leaving ZnO coated PVC foil.

### Example 5

As 3, but after separation from the nickel foil the PVC foil with ZnO and Cu film was dipped in a solution of 100 g/l potassium ferricyanide and 100 g/l glycolic acid and at pH 11 and 60 °C. After 15 minutes the copper film was completely dissolved in the solution leaving ZnO coated PVC foil.

### Example 6

As 3, but after separation from the nickel foil the PVC foil with ZnO and Cu film was dipped in a solution of 100 g/l sodium persulphate and 100 g/l citric acid and at pH 9 and 40 °C. After 15 minutes the copper film was completely dissolved in the solution leaving ZnO coated PVC foil.

## Claims

1. A process for preparing a flexible substrate onto which a film of a transparent conductive oxide has been applied, which process comprises the steps of:
(a) providing a metal carrier;
(b) depositing a film of a transparent conductive oxide onto the metal carrier;
(c) adhering a flexible substrate onto the film of the transparent conductive oxide; and
(d) removing the metal carrier from the film of the transparent conductive oxide.

2. The process according to claim 1, wherein the metal carrier is a foil of copper, nickel, steel, stainless steel, aluminium, gold, molybdenum, tungsten, tin, titanium, zinc, or any alloy thereof.

3. The process according to claim 2, wherein the metal carrier is a foil of copper or nickel.

4. The process according to any one of claims 1-3, wherein the transparent conductive oxide is selected from the group consisting of ZnO, In₂O₃, SnO₂, CdO, PbO, NiO, Co₂O₃, Cu₂O, Ag₂O, Al₂O₃, Ga₂O₃, and doped or mixed oxides thereof.

5. The process according to claim 4, wherein the transparent conductive oxide comprises ZnO or SnO₂.

6. The process according to claim any one of claims 1-5, wherein the transparent conductive oxide is doped with a fluorine-containing compound.

7. The process according to any one of claims 1-6, wherein in step (b) the film of the transparent conductive oxide is deposited onto the metal carrier by means of a gas-phase deposition process or a wet chemical deposition process.

8. The process according to claim 7, wherein in step (b) the film of the transparent conductive oxide is deposited onto the metal carrier by means of a wet chemical deposition process.

9. The process according to any one of claims 1-8, wherein the flexible substrate is adhered to the film of the transparent conductive oxide by means of an adhesive.

10. The process according to any one of claims 1-9, wherein the flexible substrate comprises a polymer or a textile.

11. The process according to claim 10, wherein the flexible substrate comprises a polymer.

12. The process according to claim 11, wherein the polymer comprises polyethylene terephthalate, polyethylene naphthalate, polyvinylchloride, polystyrene, polyethylene, polyamide, poly(tetrafluoroethene) or polyimide.

13. The process according to claim 12, wherein the polymer is polyethylene naphthalate.

14. The process according to any one of claims 1-13, wherein in step (d) the metal carrier is mechanically removed from the film of the transparent conductive oxide.

15. The process according to any one of claims 1-14, wherein between steps (a) and (b) the metal carrier is chemically passivated and a metal film is deposited on the passivated metal carrier, the film of the transparent conductive oxide is deposited in step (b) onto the metal film, whereby after step (d) the metal film is removed from the film of the transparent conductive oxide.

16. The process according to claim 15, wherein the metal carrier is chemically passivated by means of chromic acid or nitric acid.

17. The process according to claim 15 or 16, wherein the metal film is deposited onto the metal carrier by means of a wet chemical deposition process.

18. The process according to any one of claims 15-17, wherein the metal film is a film of copper, nickel, cobalt, tin, silver, manganese, indium or zinc.

19. The process according to claim 18, wherein the metal film is a film of copper or silver.

20. The process according to any one of claims 15-19, wherein in step (b) the film of the transparent conductive oxide is deposited onto the metal carrier by means of a vacuum deposition process or a wet chemical deposition process.

21. The process according to claim 20, wherein in step (b) the film of the transparent conductive oxide is deposited onto the metal carrier by means of a wet chemical deposition process.

22. The process according to any one of claims 15-21, wherein after step (d) the metal film is removed from the film of the transparent conductive oxide by selectively dissolving the metal film in a solution.

23. The process according to claim 22, wherein the solution comprises an oxidiser and a complex forming agent to dissolve the metal, and the solution has a pH in the range of 7-11.

24. The process according to claim 23, wherein the oxidiser is selected from the group consisting of persulphates, peroxides, dissolved oxygen, ferricyanides, and chlorates.

25. An electronic device comprising a flexible substrate as obtained in any one of claims 1-24.
